# EUROPEAN PATENT SPECIFICATION

(11) **EP 0 664 665 B1**
(45) Date of publication and mention of the grant of the patent: **09.07.1997**
(21) Application number: 95100778.0
(22) Date of filing: 20.01.1995
(51) Int. Cl.: H05K 13/04

(54) **A mounting device for mounting components at specific positions**
Eine Vorrichtung zum Montieren von Komponenten in spezifische Positionen
Un dispositif de montage pour fixer des composants dans des positions spécifiques

(30) Priority: 21.01.1994 JP 5240/94
(43) Date of publication of application: 26.07.1995
(73) Proprietor: YAMAHA HATSUDOKI KABUSHIKI KAISHA, Iwata-shi Shizuoka-ken (JP)
(72) Inventor: Egashira, Kenji, c/o Yamaha Hatsudoki K.K., Iwata-shi, Shizuoka-ken (JP); Yamada, Naoji, c/o Yamaha Hatsudoki K.K., Iwata-shi, Shizuoka-ken (JP)
(74) Representative: Grünecker, Kinkeldey, Stockmair & Schwanhäusser Anwaltssozietät

(56) References cited:
- WO-A-90/09732
- PATENT ABSTRACTS OF JAPAN vol. 16 no. 162 (E-1192) ,20 April 1992 & JP-A-04 011799

## Description

The present invention relates to a mounting device for mounting components at specific positions, especially chip components onto printed circuit boards, comprising a moveable head unit having at least one pickup nozzle for picking up components from a component supply unit, said pickup nozzle being slideably supported in said mounting head and actuated by an actuating assembly including a rocker arm engaging said pickup nozzle and a first driving means for driving said rocker arm, said driving means including a rotatable cam device engageable with said rocker arm.

Conventionally, a mounter is known as a device having a head unit provided with a chip component suction nozzles for picking up small electronic components such as integrated circuit chips and transferring them to a positioned printed circuit board, the components are then mounted at specified positions on the printed circuit board. Recently, to improve the chip component pickup and mounting efficiency, a mounter has been proposed in which a plurality of nozzles are mounted in the head unit so that a plurality of chip components can be picked up at one time from a component supply side and mounted on the printed circuit board.

Such a mounter having a head unit loaded with a plurality of nozzles must function so that each nozzle operates in sequence to pickup the chip component for mounting. To meet that need, a mounter has been proposed: (for instance JP-A-04 011 799) at the camshaft connected to the motor which is the power source, a raising/lowering cam is provided for each nozzle, and a rocker arm is installed to raise each nozzle according to the rotation of each cam, and the rocker arm is made to be capable of engaging with and disengaging from the cam.

In a mounter of this type, after the rocker arm and the cam are brought to a state capable of coming into contact with each other, the rocker arm is pressed down by the cam according to the rotation of the camshaft, and the nozzle for the applicable rocker arm lowers to pick up and mount the chip component.

Generally, in continuous operation of the nozzle, when the nozzle reaches the upper end of the cam operating range, the rocker arm is switched to a position capable of coming into contact with the cam and the nozzle is lowered. After the chip component is picked up and mounted the nozzle once again returns to the upper end and the cam for the next rocker arm switches to a position capable of coming into contact with the next cam and this process is repeated.

In this way, the nozzle is raised and lowered by the rotation of the cam at a low speed preventing problems such as nozzle vibration and as a consequence, dropping of the picked up components and misaligned component pickup.

However, due to factors such as current advances in reducing component size, and accordingly reduced necessary suction force of the nozzle, the nozzle holding a component has become less vulnerable to vibration during the rising and lowering of the nozzle. Thus, there is room for improvement in efficiency for mounters such as mentioned above having a cam whose rotation moves the nozzle at a slow speed up and down. Mounters are available utilizing servomotors to directly move the nozzle up and down. Even in that case, they have the fault that when the up and down stroke is relatively small, the nozzle cannot he raised and lowered at a sufficiently fast speed.

One method conceivable to improve mounter efficiency is to utilize an air cylinder as a drive source to raise and lower the nozzle. This would improve the vertical speed of the nozzle. However, the nozzle elevator devices utilizing an air cylinder as the drive source have the following disadvantages.

First, this kind of device raises and lowers the nozzles by suctioning and draining pressurized air into and out of the cylinder and therefore different types of components can make nozzle height adjustment troublesome during component pickup and mounting.

Moreover, the speed is rather difficult to control in this kind of device so dropping of components is prone to occur due to vibration when the nozzle rises and lowers. For instance, when picking up and mounting a large-size chip component, temporarily raising and lowering the nozzle at slow speed and preventing vibration during up and down movement of the nozzle is difficult.

Further, deviations are prone to occur in the air cylinder while driving the nozzles and setting a uniform time period for nozzle movement from the upper to lower end is troublesome so that when multiple nozzles arranged side by side for successive operation, the operation timing adjustment for each nozzle is not accomplished easily.

Another problem when using an air cylinder as drive source to raise and lower nozzles is the extremely sudden rising and lowering movement of the nozzles so that when the nozzle reaches the upper or lower end, an impact force occurs, causing problems such as misalignment, dropping or other damage when picking up the chip component.

Accordingly, it is an objective of the present invention to provide an improved mounting device which can combine a high nozzle speed and a yet reliable and smooth pickup of the components so as to increase the mounting efficiency.

According to the present invention, this objective is performed in that a second driving means is provided for driving said rocker arm.

Accordingly, the pickup nozzle can be moved by two different driving means with different speeds. That allows it to adapt the nozzle speed to different attraction periods and to different types of components, thereby considerably increasing the mounting efficiency.

According to a preferred embodiment of the present invention, the second driving means comprises a drive cylinder unit, said drive cylinder unit pivotably supporting said rocker arm.

According to a further preferred embodiment, the cam device is comprised of a camshaft rotatably supported in said head unit and provided with a cam for engaging the rocker arm, said camshaft being rotated by a cam drive unit.

Thus, the pickup nozzle can be smoothly moved at low speed by means of rotating the camshaft engaging the rocker arm and, on the other hand, the pickup nozzle can be moved at high speed by means of actuating the rocker arm through said drive cylinder unit.

According to another preferred embodiment, a control unit is provided for controlling said first driving means and/or said second driving means. The provision of such a control unit allows it to control the interaction of both the driving means, particularly the timing of the operation of both driving means so as to adapt the nozzle speed to the different phases of the pickup process and the mounting process respectively.

Thus, it is possible, for example, to lower the nozzle from its upper end position to its bottom end position in one stroke at high speed, when the camshaft is rotated into a position with its cam being positioned corresponding to a specified lower retaining position for the pickup nozzle, before the drive cylinder unit is actuated to bring said rocker arm into contact with said cam and to move said pickup nozzle to its bottom position. On the other hand, it is also possible to actuate said drive cylinder unit to bring the rocker arm into contact with the cam and to move said pickup nozzle towards its bottom position, before the camshaft is rotated into said specified lower retaining position, thus moving the pickup nozzle smoothly at low speed, when it is close to its bottom end position.

According to yet another further embodiment of the present invention, a damping member is provided for absorbing the impact occurring when the pickup nozzle approaches its upper end position.

Further preferred embodiments of the present invention are laid down in further dependent claims.

Hereinafter, the present invention is illustrated and explained in greater detail by means of preferred embodiments thereof in conjunction with accompanying drawings, wherein:
Figure 1 is a schematic plan view showing a mounting device with a nozzle elevator mechanism according to a preferred embodiment of the invention,
Figure 2 is a schematic front view of the mounting device according to the embodiment of figure 1, said mounting device comprising a moveable head unit including a plurality of pickup nozzles,
Figure 3 is a vertical cross-sectional front view of the essential portions of the head unit of the mounting device according to figure 1,
Figure 4 is a plan view of the essential portion of the head unit according to the embodiment of figure 1,
Figure 5 is a vertical cross-sectional side view of the head unit, wherein a pickup nozzle engaged with a rocker arm and a cam device and a drive cylinder unit for actuating said rocker arm are shown,
Figure 6 is a flow chart showing the control process for the pickup nozzle according to the first embodiment of this invention,
Figure 7 is a flow chart showing the control process in a first mode according to the embodiment of figure 6,
Figure 8 is a flow chart showing the control process in a second mode according to the embodiment of figure 6,
Figure 9 is an explanatory illustration of the operation of the cam device and the drive cylinder unit for actuating the rocker arm according to the first mode of the control process shown in figure 7,
Figure 10 is an explanatory illustration, similar to figure 9, of the operation of the cam device and the drive cylinder unit according to the second mode of the control process shown in figure 8,
Figure 11 is a flow chart showing the control of the pickup nozzle movement according to a second embodiment of this invention.

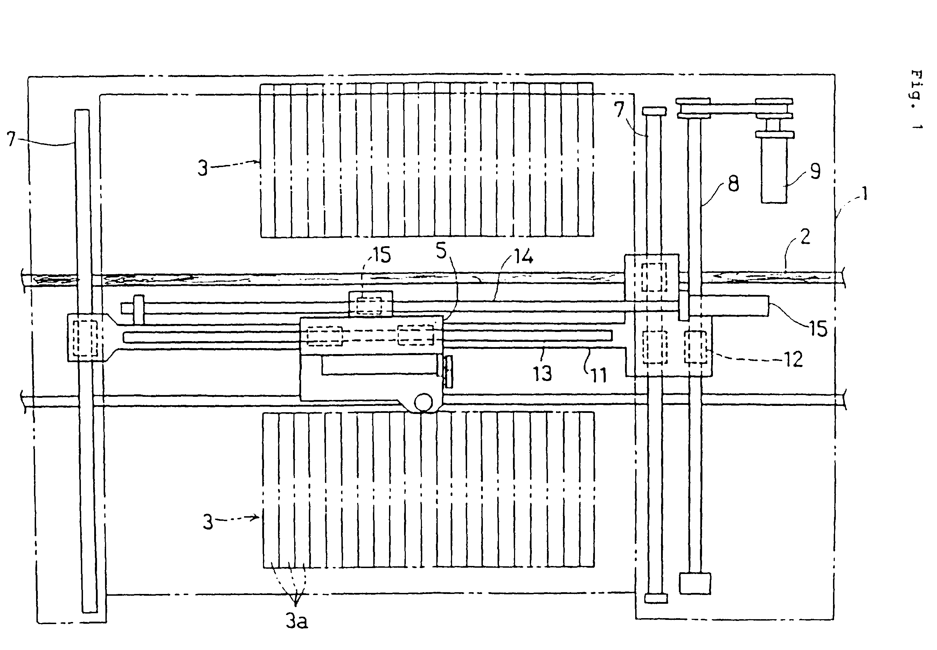

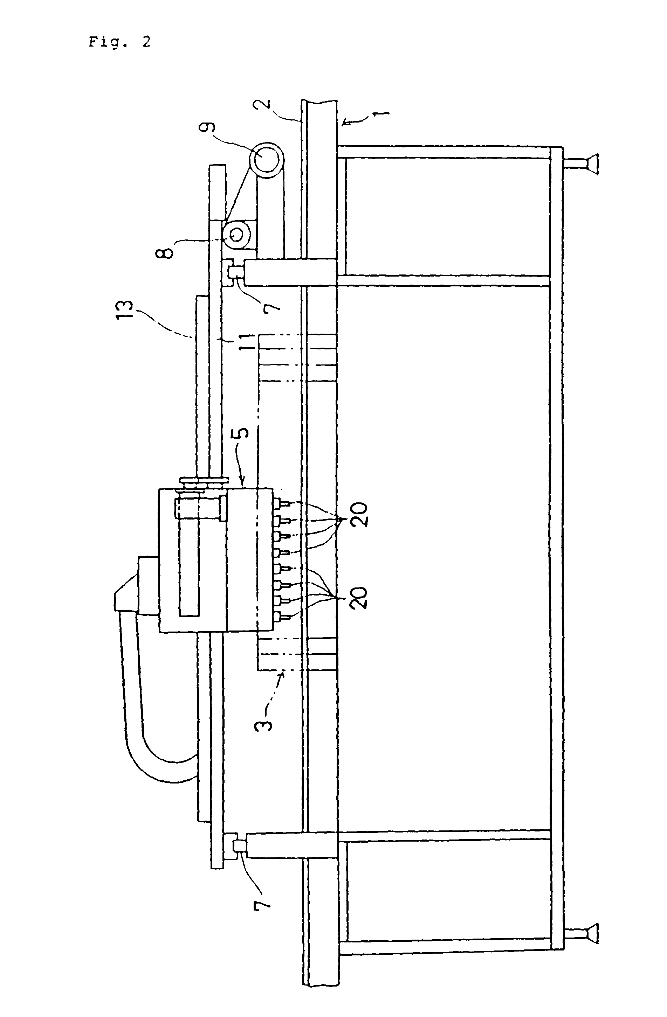

FIGs 1 and 2 show the overall structure of an embodiment of the mounter of this invention. A conveyor 2 comprising a conveyor line is arranged on a frame 1. A printed circuit board (hereinafter called as PCB) (not shown) is fed along on the conveyor 2 and stops on reaching a specified mounting position.

A component (part) supply section 3 is located on either side of the conveyor 2. The parts supply section 3 is capable of supplying many different types of chip components. For instance many units of supply tapes 3a, each wound on a reel, is provided. On each supply tape 3a are provided respectively, small chip components such as ICs, transistors and capacitors each retained at fixed intervals from each other. As the chip components are fed out by a feed-out mechanism (not shown), supply tape 3a is fed out intermittently.

A head unit 5 is installed above the frame 1 and can move in the X axis (direction of the conveyor 2) or Y axis direction (direction crossing the X axis at right angles on a horizontal plane).

A pair of fixed rails 7 extending in the Y direction and a ball screw axis 8 rotatably driven by a Y axis servomotor 9 are located on the frame 1. A head unit support member 11 is installed on the fixed rails 7. A nut 12 provided on the support member 11 is in screw engagement with the ball screw axis 8. A ball screw axis 14 is located on the support member 11 and is rotatably driven by an X axis servomotor 15 along a guide member 13 extending in the X axis direction. The head unit 5 is movably supported by the guide member 13. A nut 15 mounted in the head unit 5 is in screw engagement with the ball screw axis 14. When the ball screw axis 8 is rotated by the operation of the Y axis servomotor 9, the support member 11 moves in the Y axis direction. When the ball screw axis 14 is rotated by the operation of the X axis servo motor 15, the head unit 5 moves in the X axis direction along the member 11.

A plurality of nozzles 20 are arranged side by side in the head unit 5. Eight units of nozzle members 20 are provided as shown in the figures for the embodiment.

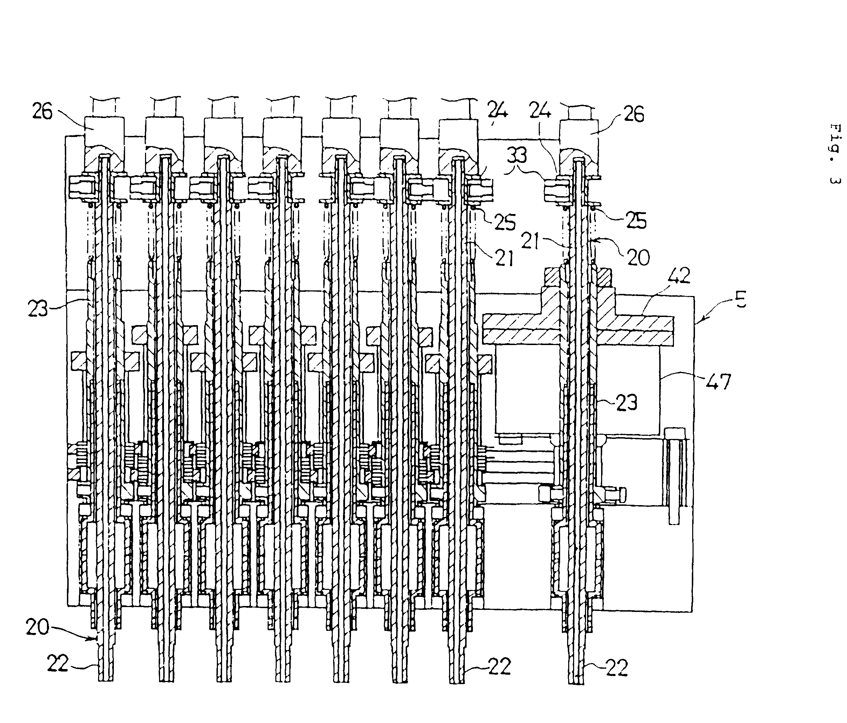

Figures 3 through 5 show a specific structure of the nozzle elevator device. As these figures show, each nozzle member 20 has a hollow shaft 21 the tip of which is an open end structure, a nozzle 22 formed as an integrated piece with the hollow shaft 21. Each nozzle member 20 inserted in a tubular housing 23, and is movable along the Z axis (up and down) with respect to the housing 23 by spline fitting to be prevented from rotation relative to the housing 23. Housing 23 is rotatably supported in the head unit 5 and therefore each nozzle member 20 is capable of rotating together with the housing 23 about an R axis (nozzle center line) of the head unit 5.

The nozzle-shaped portion at the tip of the nozzle member 20 protrudes beyond the lower part of the housing 23. The upper portion of the nozzle member 20 protrudes beyond the upper part of the housing 23. This portion has a flange 24 to be engaged with a rocker arm 33 and is provided with a return spring 25 to push the nozzle member 20 upward. The internal passage of the nozzle member 20 is connected with a vacuum pressure source (not shown) by way of a passage in a rod 27 (to be described later) and selector valves.

The upper portion of each nozzle member 20 is provided with a damper mechanism to cushion the impact force occurring when the nozzle member rises. This damping mechanism is comprised of a rod 27 and a damper cylinder 28 provided in each nozzle member 20. Each rod 27 has an integral piston 27a positioned inside an air cushion cylinder 28. At the opposite lower end, a contact piece 27b is installed for coming into contact with the nozzle member upper end. An air cushion chamber 28a is provided above the piston 27a. As the rod 27 rises upward, the air inside the air cushion chamber 28a is compressed, providing a cushioning effect for the rod 27. The cushioning effect is adjusted by a leak hole 28b connecting to the air cushion chamber 28a, and by a throttle 28c which constricts to adjust the amount of leakage, and also by a spring 27c interposed between the contact piece 27b and the cylinder body.

Further, a nozzle member elevator mechanism, and a nozzle member swivel mechanism are provided in the head unit 5.

The nozzle elevator mechanism comprises a camshaft 31 driven by a Z axis servomotor 30, and a rocker arm 33 and an air cylinder 35 provided for each nozzle member 20. The cam shaft 31 extends in the arrangement direction of the nozzle member array and is supported and held to swivel in the head unit 5, and is connected to the Z axis servomotor 30 by way of pulleys 36 and 37 and a belt 38. A cam 32 for raising and lowering the nozzle member 20 is provided at each location on the camshaft 31 corresponding to each nozzle member 20.

The rocker arm 33, has a cam follower 33a at its mid-section to contact the cam 32, and at its one end a pin 33b to engage with the rocker arm flange 24 of the nozzle member 20, and at its other end a joint 33c connecting to the upper end of a rod 34 of the air cylinder 35.

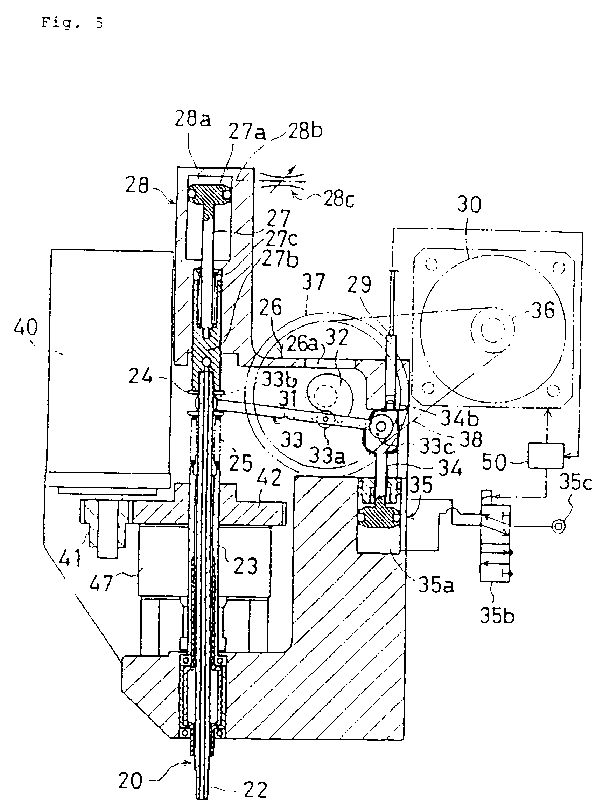

The lower end of the rod 34 has an integral piston 34a positioned in the air cylinder 35. The air cylinder 35 has a compression chamber 35a below the piston 34a. The pressure chamber 35a is connected to an air source 35c by way of an on/off selector valve 35b. Air pressure supplied to the air pressure chamber 35a from the air cylinder 35 drives the piston 34a upward and maintains the rod 34 in a raised position (the state shown in FIG. 5). It is arranged that in the state of the air cylinder 35 at rest with air evacuated from the air cylinder 35 through the air pressure chamber 35a, the rod 34 lowers to the bottom end of its vertical movement range.

A protrusion 34b is provided at the upper end of the rod 34, namely at the portion of the rocker arm 33 connecting to the joint 33c. A sensor 29 is provided in the main body of the head unit 5 to detect the protrusion 34b. This sensor comprises, for instance, a proximity switch and detects the protrusion 34b when pressurized air supplied from the pressure chamber 35 places the rod 34 at the upper end. The sensor 29 constitutes a detection means for sensing the completion of movement of the air cylinder 35 to a specified position.

The component described above, such as the camshaft 31, sensor 29 and air cushion cylinder 28 are arranged in an upper frame 26 of the head unit 5. In the embodiment the upper frame 26 is detachably installed on the other frames of the head unit 5. An opening 26a is formed at a location, above the camshaft 31, on the upper frame 26, for making visual checks. In other words, an operational check of the drive mechanisms of the cam 32. rocker arm 33 and air cylinder 35 can be visually done from outside through the punched hole 26a. The upper frame 26 can be removed for easily carrying out maintenance as needed.

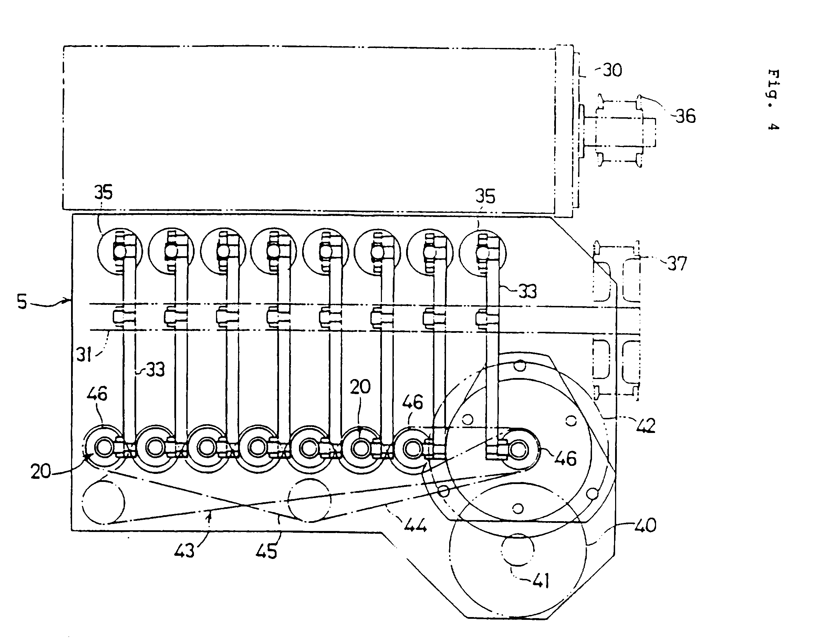

The rotary drive mechanism for each nozzle member comprises an R axis servomotor 40 used as a drive source, and a drive gear 41 installed on the axis of the R axis servomotor 40, and a driven gear 42 installed on one of the nozzle members 20 (for instance the nozzle member at the right end in FIG. 3 and FIG. 4), to mesh with the drive gear 41, and a belt transmission 43 arranged between that nozzle member 20 and other nozzle members 20. The belt transmission 43 is constructed in two levels, upper and lower to reliably transfer power, with upper and lower belts 44 and 45 each wound around a pulley 46 provided at each nozzle member 20. Thus, along with rotation of one nozzle member 20 from the R axis servomotor 40 by way of the gears 41 and 42, the rotation is also transmitted to the other nozzle members 20.

This mounter is also provided with a controller (control means) 50 comprising a microcomputer, and servomotors 9 and 15 for moving the head unit, servomotors 30 and 40 for nozzle member 20, on/off selector valve 35b as well as the sensor 29 are all electrically connected to the controller 50 and are centrally controlled by the controller 50.

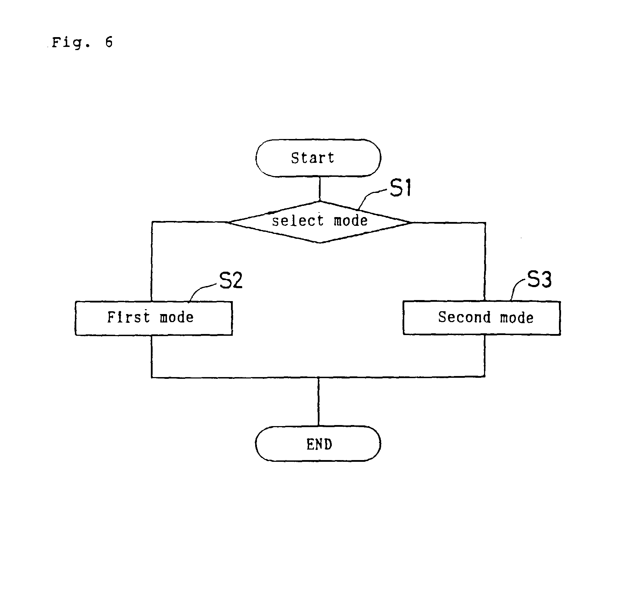

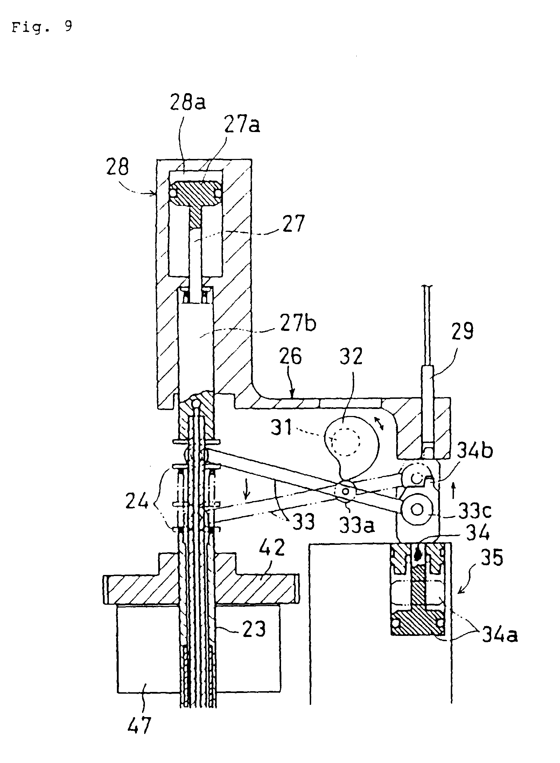

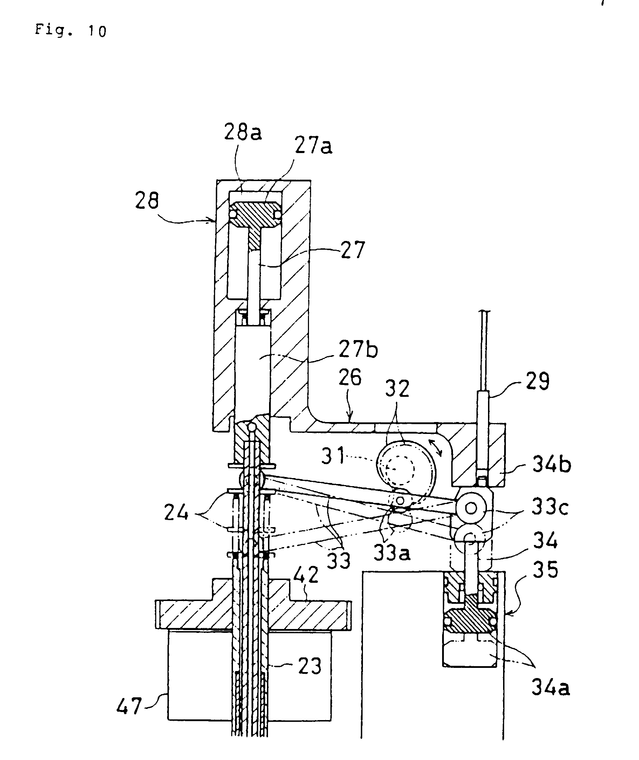

FIGs. 9 and 10 illustrate the first embodiment of the nozzle elevator mechanism and a description is given of the flow charts in FIGs. 6 through 8. Since nozzle elevator operation in the mounter is basically the same during component pickup and during component mounting, the following description relates control operation during component pickup.

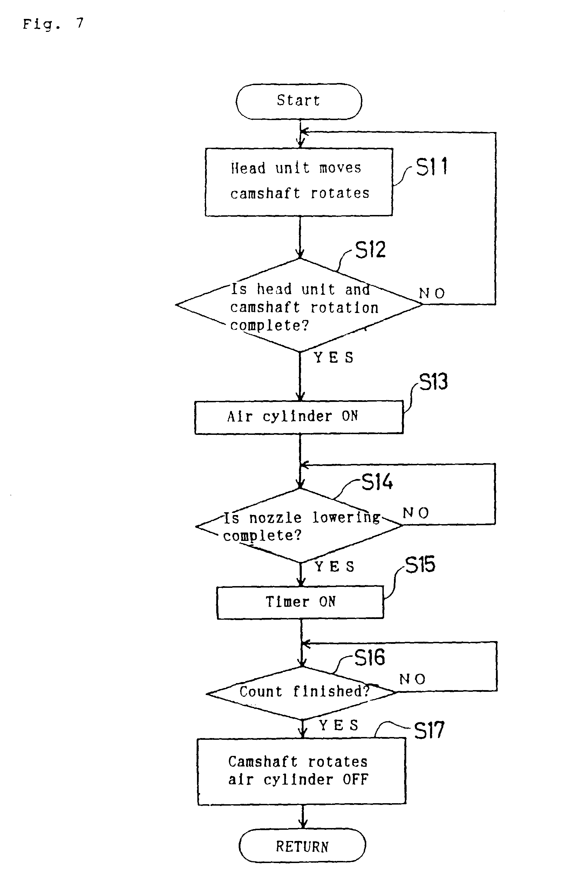

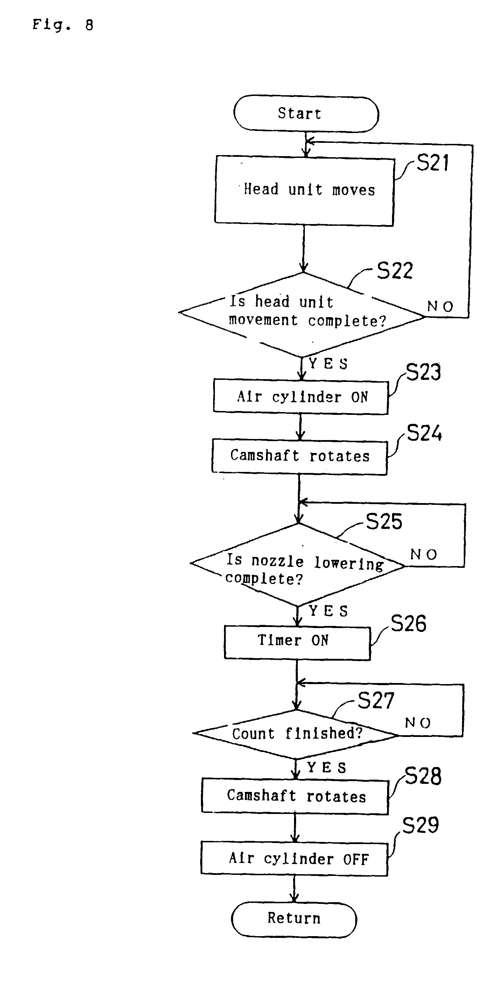

According to FIG. 6, when mounter operation starts, first, in the step S1, the mounter mode is selected according to input setting. Here, when the first mode is selected, the process shifts to the step S1, and mounter operation is performed according to the flow chart shown in FIG. 7. Likewise, when the second mode is selected, the process shifts to the step S3 shown by the flow chart in FIG. 8.

When the first mode is selected in step S1, the process shifts to the step S2 and mounter operation is performed in accordance with the flow chart shown in FIG. 7.

In the first mode, the head unit 5 is moved in the X-Y directions to be positioned above the component supply section 3, while vacuum is applied to the nozzle member 20. Operation of the Z axis servomotor 30, while the head unit 5 is being moved, rotates the cam shaft 31, and the cam 32 rotates to a position corresponding to the specified lower retaining position for the nozzle member according to the type of the chip component. In other words, the cam 32 is maintained in the state shown in FIG. 9 (steps S11 and S12).

When the above movements are complete (YES in the step S12), the process continues to the step S13. Here, the air cylinder 35 for the nozzle member 20 that must pickup the chip component, is driven by air supplied to the pressure chamber 35a, and the rod 34 is displaced from the lower end position shown by the solid lines in FIG. 9 to the upper position indicated by the dash-and-double-dotted lines. At this time, since the cam shaft 31 has already been rotated and the cam 32 is maintained at the position corresponding to the specified lower retaining position for the nozzle member, when the rod 34 is raised by the operation of the air cylinder 35, the rocker arm 33 comes in contact with the cam 32, and at the same time the rocker arm 33 is swung about the contact point between the rocker arm 33 and the cam 32, with the contact point serving as a fulcrum, and the nozzle member 20 lowers to a specified height position very close to the chip component, namely to the bottom end in one stroke.

When the nozzle member 20 lowers to the bottom end, in other words when the rod 34 is completely raised, and the protrusion 34b provided at the joint between the rocker arm 33 and the rod 34 is detected by the sensor 29 (YES in the step S14), measurement of a small time interval preset on am internal timer in controller 50 commences (step 15). In other words, by maintaining the nozzle member 20 at the bottom end for a small amount of time, a sufficient vacuum pressure for reliable pickup of the chip component is ensured.

When according to the timer, the preset amount of time elapses (YES in the step S16), the camshaft 31 is rotated by the Z axis motor 30 simultaneously with the stop of the air cylinder 35 (with air evacuated from the pressure chamber 35a), the rod 34 is gradually displaced to the lower position shown by the solid lines in FIG. 9 and the nozzle member 20 while still holding the picked up component, is raised to the top end in one stroke by the force of return spring 25. Thus, the pickup of the chip component by the nozzle member 20 is now complete (step S17).

While the nozzle member 20 is moved up and down for pickup of the chip component. the other nozzle members 20 remain at rest because corresponding air cylinders 35 are not operated (with air evacuated from the pressure chamber 35a). In other words, the rod 34 is maintained at the lower position shown by the solid lines in FIG. 9 because the air cylinders 35 are at rest and the nozzle members 20 are maintained at the upper position by the return spring 25.

Continuous up and down movement of each nozzle member 20, for successive chip component pickups with the nozzle member 20, is carried out by repeatedly performing the step S11 through step S17. At this time, the positioning of the cam 32 for the steps S11 and S12, or the amount of rotation of camshaft 31 is adjusted whenever necessary according to the type of the chip component, this in turn allows the up and down movement of the nozzle member 20 to be adjusted according to the chip component height. However, when making successive pickups of the same type chip components, the Z axis servomotor 30 is not operated repeatedly while the chip components are picked up by other nozzle members 20 by means of movement of the head unit 5 and the air cylinder 35 driving the corresponding nozzle member 20, with the cam 32 remaining in the position corresponding to the specified lower retaining position for the nozzle member.

When movement of the head unit unit 5 is not needed, a plurality of the nozzle members 20 are operated simultaneously and a plurality of the chip components are picked up at the same time.

When the second mode is selected at step S1 in FIG. 6, the process proceeds to step S3 and the mounting operation is carried out according to the flow chart in FIG. 8.

In the second mode, the head unit 5 is moved in the X-Y directions and positioned above the component supply section 3, vacuum is applied to the nozzle member 20 (steps S21 and S22), and the process proceeds to step S23.

In step S23, the air cylinder 35 for the nozzle member 20 that must pickup the chip component is driven by air supplied from the pressure chamber 35a, and the rod 34 is displaced from the lower end position indicated by the dash-and-dotted lines in FIG. 10 to the upper position indicated by the solid lines. Then by the operation of the Z axis servomotor 30, along with the rotation of the cam 32, the rocker arm 33 is swung about a fulcrum, namely the point of contact 33c with the rod 34, and the nozzle member 20 lowers accordingly (step S24).

Next, the rocker arm 33 reaches the set lower retaining position for the nozzle member according to the type of the chip component (height) as indicated by the dash-and-double-dotted lines in FIG. 10 and, when the nozzle member 20 lowers to the bottom end in response (YES in step S15), measurement of the small time interval preset on an internal timer in the controller 50 commences just as in the first mode (step 26).

When according to the timer, the preset amount of time elapses (YES in the step S27), the camshaft 31 is rotated and in response, the nozzle member 20 while still holding the picked up component, is raised to the top end in one stroke by the force of the return spring 25, then with the stop of the air cylinder 35 (with air evacuated from pressure chamber 35a), the rod 34 is gradually displaced to the lower position indicated by the dash-and-dotted lines in FIG. 10 and pickup of the chip component by nozzle member 20 is now complete (steps S28 and S29).

In this way, while the nozzle member 20 is moved up and down for pickup of the chip component, the other nozzle members 20 remain at rest because the corresponding air cylinders 35 are not operated (with air evacuated from pressure chamber 35a). Continuous up and down movement of each nozzle member 20, for making successive chip component pickups with the nozzle member 20, is carried out by repeatedly performing the steps S21 through S29.

It will be understood that the first embodiment as described above, high speed mounter operation is emphasized when the first mode is selected, and that mounter operation for reliably retaining the chip component picked up by nozzle member 20 is emphasized when the second mode is selected.

In other words, in the first mode, simultaneously with the rod 34 being driven to the upper position by the air cylinder 35, the rocker arm 33 swings, enabling the nozzle member 20 to lower to the bottom end in one stroke and after completion of chip component pickup and mounting, the air cylinder 35 immediately turns off and displacement of the rode 34 to the bottom end enables the nozzle member 20 to rise to the top end in one stroke by the force of the return spring 25. Thus, up and down movement of the nozzle member 20 is performed at high speed by the air cylinder 35 and the return spring 25, and consequently mounting operation is carried out at high speed.

In contrast, in the second mode after the rod 34 is driven to the upper position by the air cylinder 35, the nozzle member 20 lowers according to the rotation of the cam 32 caused by the operation of the Z axis servomotor 30. After the chip component pickup is complete, the nozzle member 20 is raised at a moderate speed according to the rotation of the cam 32 driven by the Z axis servomotor 30. Then the air cylinder 35 is deactivated so that the nozzle member 20 is raised at a high speed by the return spring 25. Thus, the up and down movements are always controlled at a moderate speed with less vibration and impact on the nozzle member 20 when the nozzle member 20 is within a certain vicinity of the chip component position, and at a high speed when the nozzle member 20 is outside such vicinity. Consequently the chip component picked up by the nozzle member 20 is held in a stabilized manner.

In this way, selective mounter operation is made between the first mode and the second mode, each carrying out a different operation. For instance, when the nozzle member 20 mounts a relatively small, easy to pickup, chip component, the first mode is selected allowing high speed mounting operation. When nozzle member 20 mounts a relatively large component such (such as a QFP), on the other hand, second mode is selected to prevent misaligned pickup of the chip component. Furthermore, in either mode the amount of the camshaft 31 rotation can be changed, allowing adjustment of the bottom end position of the nozzle member 20 for nozzle vertical movement, thus permitting optimal chip component pickup to be performed according to the different types of chip components.

In the first mode in particular, though the device is of the type in which the nozzle member 20 is driven in vertical movements by the air cylinder 35 as described above, the bottom end position of the nozzle member 20 is adjustable and only the rotation of the camshaft 31 is enough for the bottom end position adjustment. As a result, reduction in the nozzle operation time and improvement in the bottom end adjustment function is provided.

After pickup and mounting of the chip component in the first mode, as described above, the nozzle member 20 is raised in one stroke by means of the force of the return spring 25. As a result, an impact force is applied to the nozzle member 20 on reaching the top end, and this could possibly cause troubles such as dropping the chip components which were picked up for mounting. However, in the mounter of this embodiment, the damping mechanism consisting of the rod 27 and the air cushion cylinder 28 is arranged above each of the nozzle members 20 so that the impact force onto the nozzle member 20 upon reaching the top end is resiliently absorbed by the damping mechanism, and this function keeps the above mentioned problems at a minimum.

While the first or second mode can be selected for control in the first embodiment, the first mode only may be selected for instance if only extremely small chip components are to be mounted for higher component mounting efficiency.

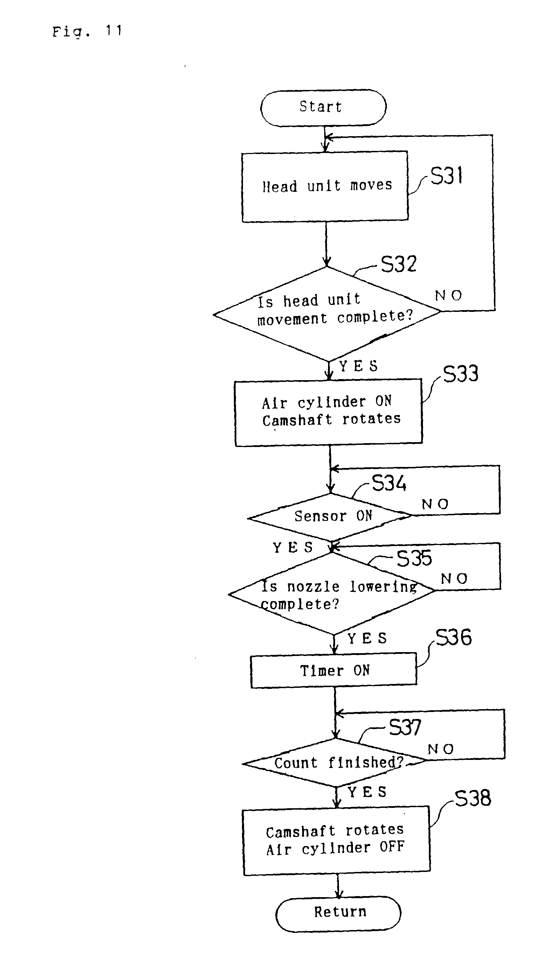

Control of the mounter operation in the second embodiment will be described below according to the flow chart in FIG. 11.

In the control process in the second embodiment, the head unit 5 is positioned above the component supply section 3, a vacuum is applied to the nozzle members 20 (steps S31 and S32) and the process proceeds to step S33.

In the step S33, the air cylinder 35 for the nozzle member 20 that must pick up the chip component is driven to displace the rod 34 to the upper position, and at the same time, the Z axis servomotor 30 is actuated to start the rotation of the camshaft 31.

When operation of the applicable nozzle member 20 starts in the step S33, the arrival (or nonarrival) of the rod 34 at the rising position is detected in step 34, in other words whether or not the sensor 29 has detected the protrusion 34b is determined, and next in the step S35 the arrival (or nonarrival) of the nozzle member 20 at the bottom end is detected. In other words whether or not the rocker arm 33 arrived at the specified lower retaining position is determined. Restated. this is an arrangement where prior to arrival of the rocker arm 33 at the specified lower retaining position, the rod 34 is made to rise to the upper position, after which the rocker arm 33 is brought to the lower retaining position by the rotation of the cam 32.

Here, while it is arranged that when the cam 32 comes into contact with the rocker arm 33, the nozzle member 20 lowers as a result of the swing of the rocker arm 33, since the rod 34 arrives at the upper position prior to the cam 32 reaching the angular position corresponding to the specified lower retaining position for the nozzle member 20, the relation between the cam 32 and the rocker arm 33 is such that, the rocker arm 33 comes in contact with the cam 32 at an operating position prior to the cam 32 arrival at the angular position corresponding to the specified lower retaining position for the nozzle member 20. This means that the nozzle member 20 momentarily lowers to a position somewhat above the bottom end at a high speed and afterwards reaches the bottom end according to the rotation of the cam 32.

Thus, when the nozzle member 20 lowers to the bottom end (YES in the steps S34 and S35), operation of the camshaft 31 comes to a stop, and a small time interval is counted by the internal timer in the controller 50 (step S36).

When the preset time elapses (YES in step S37), rotation of 31, the air cylinder 35 is deactivated to enable the rod 34 to be displaced to the lower position, and according to these actions the nozzle member 20 while still holding the picked up component raises to the top end in one stroke by the force of the return spring 25. Thus, chip component pickup with the nozzle member 20 is complete (step S38).

When the nozzle member 20 that must pick up the chip component is moved up and down, the other nozzle members 20 substantially remain stopped and maintained at the upper position by the return spring 25 because respectively corresponding air cylinders 35 are deactivated (with air evacuated from pressure chamber 35).

For example, continuous up and down movements of each nozzle member 20, for successive chip component pickups with the nozzle member 20, are carried out by repeatedly performing steps S31 through S38. The positioning of the cam 32 for the step S33, or the amount of rotation of the camshaft 31 is made similarly to the control in the first and second modes in the first embodiment according to the type of the chip component, so that the lower end position of the nozzle member 20 is adjusted according to the chip component height.

According to the previous explanation of the control in the second embodiment, driving of the air cylinder 35 and operation of the camshaft 31 start simultaneously, and prior to the cam 32 arriving at the angular position corresponding to the specified lower retaining position for the nozzle member 20, the rod 34 is displaced to the upper position, the nozzle member 20 lowers in one stroke to a position somewhat above the bottom end and then lowers slowly to the bottom end according to the rotation of the cam 32 so that a suitable speed reduction is obtained when the nozzle member 20 reaches the bottom end. This process allows the nozzle member 20 to be lowered at high speed for chip component pickup yet also allows component pickup to be performed while avoiding sudden collision between the nozzle tip and the chip component. This process also permits high speed lowering of the nozzle member 20 during mounting while avoiding chip component mounting misalignment errors caused by impacts between the chip component and a printed circuit board, thus providing a mounting operation of greater reliability.

The mounter shown in this embodiment is but one embodiment of the mounter of this invention, and the specific structure is not limited to the embodiment described here. For instance, while this embodiment is provided with eight pieces of nozzle members 20, it may also be provided with more than eight or less than eight nozzle members 20. Other changes in structure are possible without departing from the spirit and scope of this invention.

Furthermore, the two control modes described in conjunction with the first embodiment may be combined with the control mode described in conjunction with the second embodiment according to figure 11 into one embodiment, thus having three control modes between which the control unit can switch.

It is also readily apparent that the second driving means is not necessarily connected with the rocker arm, but may be alternatively connected with the camshaft which is in this case slideably supported, so as to displace the camshaft relative to the rocker arm which can be pivoted around a fixed pivot axis in this case.

As described above, the mounter as described has a drive mechanism for raising and lowering a plurality of nozzle members, consisting of a rocker arm for each nozzle member, and a camshaft provided with cams each for coming into contact with each rocker arm, and is provided with drive cylinders each to drive the rocker arm, and the camshaft drives the cam for positioning at a position corresponding to the specified lower retaining position for the nozzle member depending on the chip component, and after stopping the cam, the drive cylinder is operated. Therefore, during the mounting operation, the rocker arm is brought into contact with the cam held at the position corresponding to the specified lower retaining position for the nozzle member, the drive cylinder is operated, and the rocker arm swings to lower the nozzle member from the top end to the bottom end in one stroke. Furthermore, the amount of vertical movement of the nozzle member can be regulated according to the component chip type by adjusting the amount of camshaft rotation. As a result, reliable part pickup and mounting according to the type of chip component is accomplished while improving mounter efficiency by the use of the air cylinder as the main drive source.

During mounting, the modes are switchable between the first and second control modes. In the first control mode, first the camshaft is rotated to move the cam to the position corresponding to the specified lower retaining position for the nozzle member. Then when the drive cylinder moves in a specified direction, the nozzle member is lowered in one stroke from the top end to the bottom end. In the second control mode, first the drive cylinder is moved in a specified direction. Then the camshaft is rotated to lower the nozzle member. Thus, the mounting operation is selectable between a mode emphasizing reliable holding of the picked up chip component, and a mode emphasizing high speed mounting. Thus, functional versatility of the mounter is improved.

Further, in the above case, by providing a detection means for sensing completion of movement of the drive cylinder in the specified direction, the nozzle arrival at the lower end can be accurately timed enabling efficient, successive operation of the nozzle members when successive multiple nozzle operation is needed and as a consequence improved mounting efficiency is attained.

When the camshaft operation is made to start almost simultaneously with drive cylinder operation during pickup and mounting of the chip component, the nozzle member is lowered in one stroke to a position somewhat above the bottom end, and then arrives at the bottom end according to the rotation of the cam. This enables a suitable adjustment of the lowering speed when the nozzle must reach the bottom end, and as a consequence, along with effective use of vacuum seating pressure on the chip component when making parts pickups, misaligned mounting caused by collision of the picked up chip component with the printed circuit board can be avoided, thus ensuring a reliable parts pickup operation.

In order to prevent problems such as dropping of the chip component previously picked up by the nozzle member, a damping member is provided to resiliently absorb the impact force exerted from the nozzle during mounting. Thus, reliable chip component pickup and mounting is provided.

## Claims

1. Mounting device for mounting components at specific positions, especially chip components onto printed circuit boards, comprising a movable head unit (5) having at least one pickup nozzle (20) for picking up components from a component supply unit (3), said pickup nozzle (20) being slideably supported in said mounting head (5) and actuated by an actuating assembly including a rocker arm (33) engaging said pickup nozzle (20) and a first driving means for driving said rocker arm, said driving means including a rotatable cam device (31, 32) engageable with said rocker arm (33), **characterized in that** a second driving means (35, 35b, 35c) is provided for driving said rocker arm (33).

2. Mounting device according to claim 1, **characterized in that** said rocker arm (33) is slideably supported.

3. Mounting device according to claim 1 or 2, **characterized in that** said rotatable cam device (31, 32) is slideably supported.

4. Mounting device according to at least one of claims 1 to 3, **characterized in that** said second driving means comprises a drive cylinder unit (35), said drive cylinder unit pivotably supporting said rocker arm (33).

5. Mounting device according to at least one of claims 1 to 4, **characterized in that** said cam device is comprised of a camshaft (31) rotatably supported in said head unit (5) and provided with a cam (32) for engaging the rocker arm (33), said camshaft (31) being rotated by a cam drive unit (30).

6. Mounting device according to at least one of claims 1 to 5, **characterized in that** a control unit (50) is provided for controlling said first driving means (30, 31, 32) and/or said second driving means (35, 35b, 35c).

7. Mounting device according to claim 4, **characterized in that** said control unit (50) is adapted to control the drive cylinder unit (35) and the cam drive unit (30), in a first control mode, such that the camshaft (31) is rotated into a position with its cam (32) being positioned corresponding to a specified lower retaining position for the pickup nozzle (20), and after the camshaft rotation, the drive cylinder unit (35) is actuated to bring said rocker arm (33) into contact with said cam (32) and to move said pickup nozzle (20) to a bottom position.

8. Mounting device according to at least one of claims 6 or 7, **characterized in that** said control unit (50) is adapted to control the drive cylinder unit (35) and the cam drive unit (30), in a second control mode, such that the drive cylinder unit (35) is actuated to bring said rocker arm (33) into contact with said cam (32) and to move said pickup nozzle (20) towards a bottom position, and after the drive cylinder unit movement, the camshaft (31) is rotated into a position with its cam (32) being positioned corresponding to a specified lower retaining position for pickup nozzle (20).

9. Mounting device according to at least one of claims 6 to 8, **characterized in that** said control unit (50) is adapted to control the drive cylinder unit (35) and the cam drive unit (30), particularly in a third control mode, such that the camshaft (31) is rotated into a position with its cam (32) being positioned corresponding to a specified lower retaining position for the pickup nozzle (20), and substantially simultaneously, the drive cylinder unit (35) is actuated to bring said rocker arm (33) into contact with said cam (32) and to move said pickup nozzle (20) towards a bottom position.

10. Mounting device according to claim 9, **characterized in that** the control unit (50) is adapted to control the drive cylinder unit (35) and the cam drive unit (30), such that the rocker arm (33) is brought into contact with the cam (32) and the drive cylinder unit (35) is brought into its position corresponding to the bottom position of the pickup nozzle (20) before the cam (32) reaches its position corresponding to said specified lower retaining position for the pickup nozzle (20).

11. Mounting device according to at least one of claims 7 to 10, **characterized in that** said control unit (50) is switchable between said first, second and/or third control mode.

12. Mounting device according to at least one of claims 6 to 11, **characterized in that** sensor means (29) are provided for detecting a position of said drive cylinder unit (35) and connected with said control unit (50).

13. Mounting device according to at least one of claims 6 to 12, **characterized in that** said control unit (50) is provided with a timer unit for maintaining the pickup nozzle (20) in the bottom position for picking up components for a predetermined period of time.

14. Mounting device according to at least one of claims 1 to 13, **characterized in that** the pickup nozzle (20) is biased towards an upper position.

15. Mounting device according to at least one of claims 1 to 14, **characterized in that** a damping member (27, 28) is provided for absorbing the impact occurring when the pickup nozzle (20) approaches its upper position.

16. Mounting device according to at least one of claims 1 to 15, **characterized in that** the mounting head (5) is provided with a plurality of pickup nozzles (20), each of which has an actuating assembly (30, 31, 32, 33, 35) associated therewith.

17. Mounting device according to claim 16, **characterized in that** said plurality of pickup nozzles (20) are arranged in line, the cam device comprising a common camshaft (31) with a cam (32) provided for each pickup nozzle (20).

## Patentansprüche

1. Vorrichtung zum Montieren von Komponenten an spezifischen Positionen, insbesondere von Chip-Bauteilen auf gedruckte Leiterplatten, mit einer bewegbaren Kopfeinheit (5), die zur Aufnahme von Komponenten von einer Komponenten-Zuführeinheit (3) zumindest eine Aufnahmedüse (20) aufweist, wobei diese Aufnahmedüse (20) in diesem Montagekopf (5) gleitend gelagert sowie durch eine Betätigungsanordnung einschließlich eines Schwinghebels (33), der mit dieser Aufnahmedüse (20) in Eingriff steht, betätigbar ist, und mit einer ersten Antriebseinrichtung zum Antreiben dieses Schwinghebels, wobei diese erste Antriebseinrichtung eine rotierbare Nockenvorrichtung (31,32) enthält, die in Eingriff mit diesem Schwinghebel (33) bringbar ist, **dadurch gekennzeichnet,** daß eine zweite Antriebseinrichtung (35,35b,35c) zum Antreiben dieses Schwinghebels (33) vorgesehen ist.

2. Vorrichtung nach Anspruch 1, **dadurch gekennzeichnet**, daß dieser Schwinghebel (33) gleitend gelagert ist.

3. Vorrichtung nach Anspruch 1 oder 2, **dadurch gekennzeichnet**, daß diese drehbare Nockenvorrichtung (31,32) gleitend gelagert ist.

4. Vorrichtung nach zumindest einem der vorstehenden Ansprüche 1 bis 3, **dadurch gekennzeichnet,** daß die zweite Antriebsvorrichtung eine Antriebszylindereinheit (35) aufweist, wobei diese Antriebszylindereinheit den Schwinghebel (33) verschwenkbar lagert.

5. Vorrichtung nach zumindest einem der Ansprüche 1 bis 4, **dadurch gekennzeichnet,** daß diese Nockenvorrichtung eine Nokkenwelle (31), die in dieser Kopfeinheit (5) drehbar gelagert ist, sowie einen Nocken (32) aufweist, der mit dem Schwinghebel (33) in Eingriff bringbar ist, wobei diese Nockenwelle (31) durch eine Nockenantriebseinheit (30) in Rotation versetzbar ist.

6. Vorrichtung nach zumindest einem der Ansprüche 1 bis 5, **dadurch gekennzeichnet,** daß zur Steuerung dieser ersten Antriebseinrichtung (30,31,32) und/oder dieser zweiten Antriebseinrichtung (35,35b,35c) eine Steuereinheit (50) vorgesehen ist.

7. Vorrichtung nach Anspruch 4, **dadurch gekennzeichnet**, daß diese Steuereinheit (50) dazu ausgelegt ist, die Antriebszylindereinheit (35) und die Nockenantriebseinheit (30) in einem ersten Steuermodus derart zu steuern, daß die Nockenwelle (31) in eine Position drehbar ist, in welcher ihr Nocken (32) einer spezifizierten, unteren, zurückgezogenen Position für die Aufnahmedüse (20) entsprechend positioniert ist, wobei nach der Rotation der Nockenwelle die Antriebszylindereinheit (35) aktivierbar ist, um diesen Schwinghebel (33) in Kontakt mit diesen Nocken (32) zu bringen und um diese Aufnahmedüse (20) zu einer unteren Position zu bewegen.

8. Vorrichtung nach zumindest einem der Ansprüche 6 oder 7, **dadurch gekennzeichnet,** daß die Steuereinheit (50) dazu ausgelegt ist, die Antriebszylindereinheit (35) sowie die Nokkenantriebseinheit (30) in einem zweiten Steuermodus derart zu steuern, daß die Antriebszylindereinheit (35) aktiviert ist, um diesen Schwinghebel (33) in Kontakt mit diesen Nocken (32) zu versetzen und um diese Aufnahmedüse (22) in Richtung auf eine untere Position zu bewegen, wobei nach der Bewegung der Antriebszylindereinheit die Nockenwelle (31) in eine Position gedreht ist, in welcher ihr Nocken (32) entsprechend einer spezifizierten, unteren, zurückgezogenen Position für die Aufnahmedüse (20) positioniert ist.

9. Vorrichtung nach zumindest einem der Ansprüche 6 bis 8, **dadurch gekennzeichnet,** daß die Steuereinheit (50) dazu ausgelegt ist, die Antriebszylindereinheit (35) sowie die Nokkenantriebseinheit (33) insbesondere in einem dritten Steuermodus derart zu steuern, daß die Nockenwelle (31) in eine Position gedreht ist, in welcher ihr Nocken (32) entsprechend einer spezifizierten, unteren, zurückgezogenen Position für die Aufnahmedüse (20) positioniert ist, und wobei im wesentlichen simultan die Antriebszylindereinheit (35) aktiviert ist, um diesen Schwinghebel (30) in Kontakt mit diesen Nocken (32) zu versetzen, und um diese Aufnahmedüse (20) in Richtung auf eine untere Position zu bewegen.

10. Vorrichtung nach Anspruch 9, **dadurch gekennzeichnet,** daß die Steuereinheit (50) dazu ausgelegt ist, die Antriebszylindereinheit (35) sowie die Nockenantriebseinheit (30) derart zu steuern, daß der Schwinghebel (33) in Kontakt mit den Nokken (32) und die Antriebszylindereinheit (35) in eine Position gebracht ist, die der unteren Position der Aufnahmedüse (20) entspricht, bevor der Nocken (32) seine dieser spezifizierten, unteren, zurückgezogenen Position für die Aufnahmedüse (20) entsprechende Position erreicht.

11. Vorrichtung nach zumindest einem der Ansprüche 7 bis 10, **dadurch gekennzeichnet**, daß die Steuereinheit (50) zwischen einem ersten, zweiten und/oder dritten Steuermodus schaltbar ist.

12. Vorrichtung nach zumindest einem der Ansprüche 6 bis 11, **dadurch gekennzeichnet**, daß Sensoreinrichtungen (29) vorgesehen sind zur Erfassung einer Position dieser Antriebszylindereinheit (35), wobei diese mit der Steuereinheit (50) verbunden sind.

13. Vorrichtung nach zumindest einem der Ansprüche 6 bis 12, **dadurch gekennzeichnet,** daß die Steuereinheit (50) mit einer Zeitgebereinheit versehen ist, um die Aufnahmedüse (20) in der unteren Position zur Aufnahme der Komponenten für eine vorbestimmte Zeitperiode zu halten.

14. Vorrichtung nach zumindest einem der Ansprüche 1 bis 13, **dadurch gekennzeichnet,** daß die Aufnahmedüse (20) in Richtung auf eine obere Position vorgespannt ist.

15. Vorrichtung nach zumindest einem der Ansprüche 1 bis 14, **dadurch gekennzeichnet,** daß ein Dämpfungsglied (27,28) vorgesehen ist zum Absorbieren eines Stoßes, der auftritt, wenn die Aufnahmedüse (20) sich an ihre obere Position annähert.

16. Vorrichtung nach zumindest einem der Ansprüche 1 bis 15, **dadurch gekennzeichnet,** daß der Montagekopf (5) mit einer Vielzahl von Aufnahmedüsen (20) versehen ist, wobei jede eine ihr zugeordnete Betätigungsanordnung (30,31,32,33,35) aufweist.

17. Vorrichtung nach Anspruch 16, **dadurch gekennzeichnet,** daß die Vielzahl der Aufnahmedüsen (20) in einer Linie angeordnet ist, und daß die Nockenvorrichtung eine gemeinsame Nockenwelle (31) enthält, wobei für jede Aufnahmedüse (20) ein Nocken (32) vorgesehen ist.

## Revendications

1. Dispositif montage pour monter des composants en des positions spécifiques, spécialement des composants de puce électronique sur des plaquettes à circuit imprimé, comprenant une unité de tête (5) déplaçable, ayant au moins une buse de prélèvement (20) destinée à prélever des composants depuis une unité d'alimentation en composants (3), ladite buse de prélèvement (20) étant supportée de façon coulissante dans ladite tête de montage et actionnée par un ensemble d'actionnement comprenant un bras basculant (33) venant en contact avec ladite buse de prélèvement (20) et un premier moyen d'entraînement destiné à entraîner ledit bras basculant, lesdits moyens d'entraînement un dispositif à cames tournantes (31, 32) susceptibles de venir en contact avec ledit bras basculant (33), caractérisé en ce qu'un deuxième moyen d'entraînement (35, 35b, 35c) est prévu pour assurer l'entraînement dudit bras basculant (33).

2. Dispositif de montage selon la revendication 1, caractérisé en ce que ledit bras basculant (33) est supporté de façon coulissante.

3. Dispositif de montage selon la revendication 1 ou 2, caractérisé en ce que ledit dispositif à cames tournantes (31, 32) est supporté de façon coulissante.

4. Dispositif de montage selon au moins l'une des revendications 1 à 3, caractérisé en ce que ledit deuxième moyen d'entraînement comprend une unité à cylindre d'entraînement (35), ladite unité à cylindre d'entraînement supportant de façon pivotante ledit bras basculant (33).

5. Dispositif de montage selon au moins l'une des revendications 1 à 4, caractérisé en ce que ledit dispositif à cames est constitué d'un arbre à cames (31) supporté de façon tournante dans ladite unité de tête (5) et pourvu d'une came (32), pour assurer la mise en contact du bras basculant (33), ledit arbre à cames (31) étant entraîné en rotation par une unité d'entraînement à came (30).

6. Dispositif de montage selon au moins l'une des revendications 1 à 5, caractérisé en ce qu'une unité de commande (50) est prévue pour commander lesdits premiers moyens d'entraînement (30, 31, 32) et/ou lesdits deuxièmes moyens d'entraînement (35, 35b, 35c).

7. Dispositif de montage selon la revendication 4, caractérisé en ce que ladite unité de commande (50) est adaptée pour commander l'unité de cylindre d'entraînement (35) et l'unité d'entraînement à came (30), dans un premier mode de commande, de manière que l'arbre à cames (31) soit entraîné en rotation dans une position dans laquelle sa came (32) est positionnée en correspondance d'une position de retenue inférieure spécifiée de la buse de prélèvement (20) et que, après la rotation de l'arbre à cames, l'unité de cylindre d'entraînement (35) soit actionnée pour placer ledit bras basculant (33) en contact avec ladite came (32) et pour déplacer ladite buse de prélèvement (20) en une position inférieure.

8. Dispositif de montage selon au moins l'une des revendications 6 ou 7, caractérisé en ce que ladite unité de commande (50) est adaptée pour commander l'unité de cylindre d'entraînement (35) et l'unité d'entraînement à came (30), dans un deuxième mode de commande, de manière que l'unité de cylindre d'entraînement (35) soit actionnée pour placer ledit bras basculant (33) en contact avec ladite came (32) et pouvant déplacer ladite buse de prélèvement (20) vers une position inférieure et, après le déplacement de l'unité de cylindre d'entraînement, l'arbre à cames (31) étant tourné en une position dans laquelle sa came (32) est positionnée en correspondance vis-à-vis d'une position de retenue inférieure spécifiée de la buse de prélèvement (20).

9. Dispositif de montage selon au moins l'une des revendications 6 à 8, caractérisé en ce que ladite unité de commande (50) est adaptée pour commander l'unité de cylindre d'entraînement (35) et l'unité d'entraînement à came (30), en particulier dans un troisième mode de commande, de manière que l'arbre à cames (31) soit tourné dans une position dans laquelle sa came (32) est positionnée en correspondance d'une position de retenue inférieure spécifiée de la buse de prélèvement et, sensiblement simultanément, l'unité de cylindre d'entraînement (35) est actionnée pour placer ledit bras basculant (33) en contact avec ladite came (32), et déplacer ladite buse de prélèvement (20) vers une position inférieure.

10. Dispositif de montage selon la revendication 9, caractérisé en ce que l'unité de commande (50) est adaptée pour commander l'unité de cylindre d'entraînement (35) et l'unité d'entraînement à came (30), de manière que le bras basculant (33) soit mis en contact avec la came (32) et que l'unité de cylindre d'entraînement (35) soit placée dans sa position correspondant à la position inférieure de la buse de prélèvement (20), avant que la came (32) atteigne sa position correspondant à ladite position de retenue inférieure spécifiée de la buse de prélèvement (20).

11. Dispositif de montage selon au moins l'une des revendications 7 à 10, caractérisé en ce que ladite unité de commande (50) peut être commutée entre lesdits premier, deuxième et/ou troisième modes de commande.

12. Dispositif de montage selon au moins l'une des revendications 6 à 11, caractérisé en ce que des moyens capteurs (29) sont prévus pour détecter la position de ladite unité à cylindre d'entraînement (35) et en liaison avec ladite unité de commande (50).

13. Dispositif de montage selon au moins l'une des revendications 6 à 12, caractérisé en ce que ladite unité de commande (50) est pourvue d'une unité de minuterie, destinée à maintenir la buse de prélèvement (20) dans la position inférieure, pour prélever des composants pendant une période de temps prédéterminée.

14. Dispositif de montage selon au moins l'une des revendications 1 à 13, caractérisé en ce que la buse de prélèvement (20) est déplacée vers une position supérieure.

15. Dispositif de montage selon au moins l'une des revendications 1 à 14, caractérisé en ce qu'un organe d'amortissement (27, 28) est prévu pour absorber l'impact se produisant lorsque la buse de prélèvement (20) s'approche de sa position supérieure.

16. Dispositif de montage selon au moins l'une des revendications 1 à 15, caractérisé en ce que la tête de montage (5) est pourvue d'une pluralité de buses de prélèvement (20), chacune d'entre elles ayant un ensemble d'actionnement (30, 31, 32, 33, 35) lui étant associé.

17. Dispositif de montage selon la revendications 16, caractérisé en ce que ladite pluralité de buses de prélèvement (20) sont disposées en ligne, le dispositif à cames comprenant un arbre à cames (31) commun, une came (32) étant prévue pour chaque buse de prélèvement (20).
